# EUROPEAN PATENT SPECIFICATION

(11) **EP 3 339 243 B1**
(45) Date of publication and mention of the grant of the patent: **26.07.2023**
(21) Application number: 16206875.3
(22) Date of filing: 23.12.2016
(51) Int. Cl.: B81C 1/00

(54) **INTERCONNECTED LAYER STACK WITH VERTICALLY ALIGNED MEMS AND ASSIGNED CHIP**
INTERN VERBUNDENER SCHICHTSTAPEL MIT VERTIKAL ÜBEREINANDER ANGEORDNETEM MEMS UND ZUGEORDNETER CHIP
EMPILEMENT DE COUCHES INTERCONNECTÉES AVEC DES MEMS ALIGNÉS VERTICALEMENT ET PUCE ASSOCIÉE

(43) Date of publication of application: 27.06.2018
(73) Proprietor: AT & S Austria Technologie & Systemtechnik Aktiengesellschaft, 8700 Leoben-Hinterberg (AT)
(72) Inventor: Gmundner, Gernot, 8605 Parschlug (AT); Vockenberger, Christian, 8700 Leoben (AT)
(74) Representative: Donatello, Daniele

(56) References cited:
- US-A1- 2005 288 392
- US-A1- 2011 042 762
- US-A1- 2011 293 128
- US-A1- 2012 031 874
- US-A1- 2014 203 379
- US-A1- 2014 353 775
- US-A1- 2015 373 446

## Description

The invention relates to an electronic device and a method of manufacturing an electronic device.

Microelectromechanical systems (MEMS) is a technology that can be defined as miniaturized mechanical and electromechanical elements, including sensors and actuators, that are made using techniques of microfabrication. Critical physical dimensions of MEMS devices can vary from well below one micron to several millimeters. Types of MEMS devices can vary from relatively simple structures having no moving elements, to extremely complex electromechanical systems with multiple moving elements under the control of integrated microelectronics. In a MEMS, there may be at least some elements having some sort of mechanical functionality whether or not these elements can move.

Mounting MEMS devices on component carriers such as a printed circuit board involves technological issues since the MEMS devices often need control by a chip or are coupled with a chip for signal processing. Conventional MEMS-chip assemblies in component carrier architecture require a lot of space.

Document US 2011/293128 A1 discloses a semiconductor element comprising a cover and a substrate stacked one to each other, forming a cavity where a MEMS and a chip are accommodated to be one above the other along the stacking direction, configured to cooperate one to each other.

Document US 2014/203379 A1 discloses a device made by building up a stack containing insulating and electrically conductive layers which house a MEMS component and a microprocessor chip where a cavity is formed in the stack to house the MEMS over the microprocessor as in the preamble of claim 1.

Document US 2012/031874 discloses a method for forming a cavity to hold a MEMS chip in a wafer bilayer structure by removing a section of the upper wafer.

A method according to the invention is defined in claim 1.

According to the invention, an electronic device composed of a MEMS and a chip arranged on and/or in an interconnected (preferably laminated) integral layer stack can be manufactured in a particularly compact way. With regard to a horizontal extension, this can be accomplished by arranging the chip and the MEMS on top of one another with one being either fully enclosed within the contour of the other one or at least with an overlap in a vertical viewing direction. With regard to a vertical extension, the compactness of the electronic device is the consequence of the use of a laminated stack resulting in a flat plate-shaped geometry. Moreover, arranging the MEMS and the chip above one another without excessive mutual lateral displacement, the electric connection paths between chip and MEMS may be kept short. This results in a low amount of noise experienced by the signals propagating between MEMS and chip. Thus, a compact configuration and a reliable performance of a packaged MEMS can be synergistically combined. In particular, a MEMS functionality may be provided with a component carrier type construction.

In the following, further exemplary embodiments of the electronic device and the method will be explained. These exemplary embodiments concern specific details which are compatible with the invention as claimed but not necessarily included in the invention. The invention and embodiments of the invention are defined by the claims.

In the context of the present application, the term "lateral extension of the microelectromechanical system and lateral extension of the chip" may in particular denote a spatial range in a plane perpendicular to the stacking direction of the layer structures within which range the MEMS or the chip extends.

In the context of the present application, the term "stack" may particular denote an arrangement of multiple substantially parallel layer structures arranged on top of one another.

In the context of the present application, the term "interconnected stack" may in particular denote a stack of layer structures being connected to one another (for instance by laminating, gluing, soldering, welding, etc.) so that they form an integral body.

In the context of the present application, the term "laminated stack" may in particular denote a stack with layer structures being connected to one another by applying mechanical pressure and/or heat so that they form an integral body.

In the context of the present application, the term "viewing direction perpendicular to a main surface of the stack" may relate to a virtual axis oriented along a stacking direction of the layer structures or perpendicular to a main surface (in particular a bottom main surface of the stack, which may for instance be entirely planar) of the layer structures.

In particular, a lateral extension of the microelectromechanical system and a lateral extension of the chip may at least partially coincide, when in a viewing direction perpendicular to the main surface of the interconnected, in particular laminated, stack and towards the MEMS system, the MEMS system and the chip partially or fully overlap, more particularly in each of the following embodiments:
- when a projection of the MEMS on the planes of the layer structures fully encloses or covers a projection of the chip on the planes of the layer structures;
- when a projection of the chip on the planes of the layer structures fully encloses or covers a projection of the MEMS on the planes of the layer structures;
- when projections of the MEMS and the chip on the planes of the layer structures partially overlap so that one covers or encloses the other only partially.

In one embodiment, the chip may be configured as control chip for controlling the microelectromechanical system. In such an embodiment, the chip may send a control signal for operating the MEMS accordingly. As an example for such a configuration, the MEMS may be a loudspeaker emitting acoustic waves corresponding to a corresponding control signal provided by the chip.

In another embodiment, the chip may be configured as an analysis chip which processes signals obtained from the MEMS. In such a configuration, the MEMS may for instance be a microphone capable of detecting acoustic waves in a surrounding, wherein these acoustic waves converted into electric signals by the MEMS are then processed (for instance filtered, etc.) by the analysis chip.

In one embodiment, the microelectromechanical system is mounted above the chip. Such an embodiment is particularly advantageous, since this allows a movable component of the MEMS to be exposed to an environment for interaction with the same.

In one embodiment, the microelectromechanical system and the chip are mounted so that, in the viewing direction perpendicular to the main surface of the interconnected, in particular laminated, stack, a contour of one of the microelectromechanical system and the chip is fully enclosed within a contour of the other one of the microelectromechanical system and the chip. In such an embodiment, there is not only an overlap but a full coverage of a contour of one of the MEMS and the chip by the respectively other contour. The compactness in lateral direction is therefore particularly pronounced in such a configuration, and there is sufficient space for any other electronic tasks within the electronic device, for instance wiring or cooling tasks.

In one embodiment, the chip is embedded in an interior of the interconnected, in particular laminated, stack. By embedding the chip, i.e. fully circumferentially encapsulating the chip, within the interconnected, in particular laminated, stack, the vertical dimension of the electronic device can be kept extremely small. Furthermore, an externally substantially flat electronic device may be obtained.

In one embodiment, the microelectromechanical system is mounted in a cavity formed in a surface portion of the interconnected, in particular laminated, stack. By placing the MEMS in a cavity within the interconnected, in particular laminated, stack, the substantially flat architecture of the electronic device may be emphasized. Moreover, the MEMS may be mechanically protected within the cavity with regard to mechanical load. This increases robustness of the electronic device.

In one embodiment, an upper end of the microelectromechanical system is retracted with regard to an upper surface of the interconnected, in particular laminated, stack surrounding the cavity. In other words, a vertical height of the cavity may be higher than a vertical height of the MEMS. This promotes compactness of the electronic device while keeping the risk of damaging a sensitive movable part of the MEMS (oriented in many cases in a top region of the MEMS) during operation small.

In one embodiment, the electronic device comprises a cover structure covering at least part of the interconnected, in particular laminated, stack for protecting the microelectromechanical system. Such a cover may protect the MEMS with regard to a mechanical impact from an environment while maintaining a sensor or an actuator access to the environment.

In one embodiment, the electronic device comprises a cover structure covering part of the cavity (in particular while maintaining a gap with regard to the MEMS). Such a cover may for instance be a cover plate or a dome-shaped lid. A cover of the described type has the capability of protecting in particular a movable part of the MEMS in the cavity against mechanical impact during manufacture and operation of the electronic device.

In one embodiment, the cover has a through-hole for providing pressure communication, acoustic communication, gas communication, etc., between an interior and an exterior of the cavity. By forming one or more through-holes in the cover, an exchange between the atmosphere and the MEMS is enabled between an interior and an exterior of the covered cavity. Therefore, pressure waves and acoustic waves may propagate from an interior to an exterior of the electronic device, or vice versa. Also an exchange of chemicals, gases, vapour, liquid, etc. between an interior and an exterior of the electronic device is possible which may increase the accuracy of a corresponding sensing performance of the MEMS.

In one embodiment, the cover is a flat plate connected on an upper flat surface of the interconnected, in particular laminated, stack. When using a flat plate on top of the interconnected, in particular laminated, flat stack for at least partially covering the cavity filled with the MEMS, an entirely flat electronic device with high compactness can be obtained while simultaneously further increasing the protection of the MEMS against mechanical damage.

In one embodiment, the microelectromechanical system and the chip are electrically connected to one another at least partially via at least one of the electrically conductive layer structures. Therefore, the stack (in particular laminate) not only serves as a mounting base and/or an embedding material for chip and/or MEMS, but may also provide for an interconnection of chip and MEMS for functional cooperation. For this purpose, electrically conductive patterned layers and/or patterns of vertical through-connections may be used as electrically conductive layer structures. More specifically, the electric connection between MEMS and chip may be accomplished only via the electrically conductive structures. This renders the provision of separate electric connection elements dispensable, reduces the effort for manufacturing the electronic device and further promotes the compactness of the latter.

In one embodiment, the microelectromechanical system and the chip are electrically connected to one another at least partially by at least one bond wire extending from the microelectromechanical system to at least one of the electrically conductive layer structures. Such a bond wire may be accommodated within the cavity and may therefore also be protected by the cavity surrounding material of the interconnected, in particular laminated, stack and/or a cover.

In one embodiment, the microelectromechanical system and the chip are electrically connected to one another directly by directly connecting at least one pad of the microelectromechanical system with at least one pad of the chip (for instance by a solder connection). The described embodiment provides a high compactness, since no additional electrically conductive layer structures or other contact elements apart from the pads of chip and MEMS and optionally an additional solder material are necessary for electrically connecting chip and MEMS. Moreover, a direct electric connection of chip and MEMS arranged directly, i.e. without any other element in between, above one another, keeps the conductive paths extremely short and thereby protects electric signals exchanged between chip and MEMS from noise and other undesired influences.

In one embodiment, the microelectromechanical system and the chip are directly electrically connected to a common one of the electrically conductive layer structures. Therefore, the electric coupling between MEMS and chip may be carried out on only one single vertical level, for instance along one patterned electrically conductive foil. This allows for a compact arrangement, a reliable electric connection and a short signal path.

In one embodiment, the microelectromechanical system and the chip are electrically connected to one another at least partially by a vertical through-connection extending perpendicular to the interconnected, in particular laminated, stack. One or more additional vertical interconnects such as vias can hence be manufactured easily by drilling and plating and allow for a short path connection between chip and MEMS, even when those are separated from one another by a portion of the interconnected, in particular laminated, stack and/or other elements.

In particular, the one or more additional vertical interconnect may extend at least partially vertically parallel to at least one of the microelectromechanical system and the chip. Preferably, such a via may run in parallel to the chip. This provides for a particular compact electronic device, since the MEMS-chip coupling via(s) may then add nothing or nothing of significance to the entire vertical thickness.

In one embodiment, the chip is a semiconductor chip. In one embodiment, the MEMS is a semiconductor chip. Therefore, semiconductor technology with its compactness and high processing capabilities can be embedded in a PCB architecture.

In one embodiment, the microelectromechanical system is a sensor, in particular at least one of the group consisting of a pressure sensor, an acceleration sensor, and a microphone. However, other sensor applications are possible as well. In the context of the present application, the term "sensor" may particularly denote an element capable of generating an electric signal based on a property in the environment, which may be acoustic waves, electromagnetic radiation, or a certain matter such as a gas or a chemical.

In another embodiment, the microelectromechanical system is an actuator, in particular a loudspeaker. In the context of the present application, the term "actuator" may particularly denote an element which is triggered to be moved by an electric signal. Such an electric signal may be provided to the MEMS by the chip.

A MEMS may have a miniaturized movable element such as a membrane or a cantilever which can either be moved by an external impact (such as acoustic waves to be detected) or which may be moved by an electronic device internal stimulus (such as an electric signal applied to a piezoelectric membrane to oscillate for emitting acoustic waves in terms of a loudspeaker functionality). However, other actuator applications of the MEMS are possible as well, such as a micropump application, a microengine application, etc. In terms of sensing, the MEMS may also be a gas sensor capable of detecting certain gases from an environment.

In one embodiment, the method further comprises embedding and laminating the chip within the laminated stack. According to the invention, the method comprises forming a cavity in a surface portion of the interconnected, in particular laminated, stack, and accommodating the microelectromechanical system in the cavity. This is a simple manufacturing procedure resulting in a compact electronic device by fully embedding the chip in the laminate and placing the MEMS protected in the cavity on a recessed surface of the interconnected, in particular laminated, stack.

In one embodiment, the cavity is formed by arranging a release layer in the interconnected, in particular laminated, stack, and cutting through a portion of the interconnected, in particular laminated, stack above the release layer to thereby remove a cut-out portion of the interconnected, in particular laminated, stack above the release layer. In this context, the term "release layer" may denote a structure (for instance made of a suitable wax) buried within the interconnected, in particular laminated, stack and being capable of delaminated from surrounding layer structures of the interconnected, in particular laminated, stack without significant force impact. Thus, after having cut around exterior edges of the release layer, a portion of the interconnected, in particular laminated, stack above the release layer may be simply taken away from the remainder of the layer stack to thereby obtain the cavity. This cutting may for instance be accomplished by a laser or a mechanical drill bore.

According to the invention, the cavity is formed by forming a hollow space in an interior of the interconnected, in particular laminated, stack, and removing a portion of the interconnected, in particular laminated, stack above the hollow space. More particularly, the hollow space may be formed as a hole in at least one of the electrically insulating layer structures made of no-flow prepreg or low-flow prepreg. For instance, a pre-cut sheet of no-flow prepreg or low-flow prepreg may be used for defining the hollow space which may later form at least part of the cavity. Advantageously, the no-flow prepreg or low-flow prepreg will not or substantially not re-melt/not become flowable during lamination, so that the hole will not be closed during laminating by liquefied resin or the like.

In one embodiment, the method further comprises embedding the microelectromechanical system at least partially within a surface portion of the interconnected, in particular laminated, stack. By embedding also the MEMS partially within the stack so that it is also laterally covered by stack material, an extraordinarily compact electronic device may be obtained and in which the MEMS is almost entirely protected against damage during operation. However, a movable part (for instance a cantilever or a membrane) of the MEMS may be kept exposed to an environment to ensure that the MEMS can still fulfil its function. Preferably, the embedding is accomplished so that the movable element of the microelectromechanical system remains coupled to a surrounding atmosphere (in particular remains movable, and hence capable to fulfil its sensing or actuating function regardless of its partial embedding in the stack).

In one embodiment, the method further comprises providing a compression protection structure for temporarily (i.e. during laminating) protecting a movable element of the microelectromechanical system during laminating the laminated stack together with the microelectromechanical system. In order to at least partially embed an MEMS in a laminated stack, it is advantageous to protect at least the movable element of the MEMS during the lamination procedure which may be carried out simultaneously with the MEMS embedding procedure. For example, the MEMS structure may be temporarily covered by a mechanically protecting structure during the lamination. This structure may be removed after having served as a protection, to thereby expose the movable element to an environment before first use of the electronic device.

In an embodiment, the electronic device comprises a stack of at least one electrically insulating layer structure and at least one electrically conductive layer structure. For example, the electronic device may be a laminate of the mentioned electrically insulating layer structure(s) and electrically conductive layer structure(s), in particular formed by applying mechanical pressure, if desired supported by thermal energy. The mentioned stack may provide a plate-shaped electronic device capable of providing a large mounting surface for further components and being nevertheless very thin and compact. The term "layer structure" may particularly denote a continuous layer, a patterned layer or a plurality of non-consecutive islands within a common plane.

In an embodiment, the electronic device is shaped as a plate. This contributes to the compact design, wherein the electronic device nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the electronic device is configured as one of the group consisting of a printed circuit board, and a substrate (in particular an IC substrate).

In the context of the present application, the term "printed circuit board" (PCB) may particularly denote a component carrier (which may be plate-shaped (i.e. planar), three-dimensionally curved (for instance when manufactured using 3D printing) or which may have any other shape) which is formed by laminating several electrically conductive layer structures with several electrically insulating layer structures, for instance by applying pressure, if desired accompanied by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier having substantially the same size as a component (in particular an electronic component) to be mounted thereon. More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing spheres (such as glass spheres).

In an embodiment, the at least one electrically insulating layer structure comprises at least one of the group consisting of resin (such as reinforced or non-reinforced resins, for instance epoxy resin or Bismaleimide-Triazine resin, more specifically FR-4 or FR-5), cyanate ester, polyphenylene derivate, glass (in particular glass fibers, multi-layer glass, glass-like materials), prepreg material, polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg or FR4 are usually preferred, other materials may be used as well. For high frequency applications, high-frequency materials such as polytetrafluoroethylene, liquid crystal polymer and/or cyanate ester resins may be implemented in the component carrier as electrically insulating layer structure.

In an embodiment, the at least one electrically conductive layer structure comprises at least one of the group consisting of copper, aluminum, nickel, silver, gold, palladium, and tungsten. Although copper is usually preferred, other materials or coated versions thereof are possible as well, in particular coated with supra-conductive material such as graphene.

In an embodiment, the component carrier is a laminate-type component carrier. In such an embodiment, the component carrier is a compound of multiple layer structures which are stacked and connected together by applying a pressing force, if desired accompanied by heat. Thus, the component carrier may be formed by stacking a plurality of layer structures and connecting them by the application of mechanical pressure and thermal energy (i.e. heat).

The aspects defined above and further aspects of the invention are apparent from the examples of embodiment to be described hereinafter and are explained with reference to these examples of embodiment.

The invention will be described in more detail hereinafter with reference to examples of embodiment but to which the invention is not limited.
Figure 1 shows a cross-sectional view of an electronic device according to an example.
Figure 2 shows a cross-sectional view of an electronic device according to another example.
Figure 3 shows a cross-sectional view of an electronic device according to still another example.
Figure 4 shows a cross-sectional view of a structure obtained during carrying out a method of manufacturing a cavity of an electronic device according to an exemplary embodiment of the invention.
Figure 5 shows a cross-sectional view of a structure obtained during carrying out a method of manufacturing a cavity of an electronic device according to another exemplary embodiment of the invention.
Figure 6 shows a cross-sectional view of a structure obtained during carrying out a method of manufacturing an electronic device with a partially embedded MEMS according to an exemplary embodiment of the invention.

The illustrations in the drawings are schematical. In different drawings, similar or identical elements are provided with the same reference signs.

Before, referring to the drawings, exemplary embodiments will be described in further detail, some basic considerations will be summarized based on which exemplary embodiments of the invention have been developed.

According to an example, a MEMS-chip arrangement is integrated in a PCB in a manner for reducing the mechanical dimension of the PCB with MEMS functionality. In other words, a MEMS may be integrated in a PCB with reduced mechanical dimensions of the obtained PCB arrangement.

In an example, the combination of embedding and cavity formation for functionally coupling a MEMS and a controller or other type of chip allows to reduce the mechanical dimensions of the manufactured board as well as of its height. The entire height of the board can be determined by the required thickness of the dielectric material for embedding the MEMS and by the necessary cavity thickness defined by the component height or mounting depth. By the common use of the same copper layer(s) by the chip and the MEMS, the entire thickness can be correspondingly reduced. A small dimension of the electronic device or board can be accomplished by placing the two components at the same horizontal position, for instance with their centres of gravity flushing in a vertical direction, or at least partially overlapping or being slightly displaced but fully enveloped with one another.

The chip or controller may be embedded directly in the component board. Above the embedded chip, a cavity may be manufactured in which the MEMS may be accommodated.

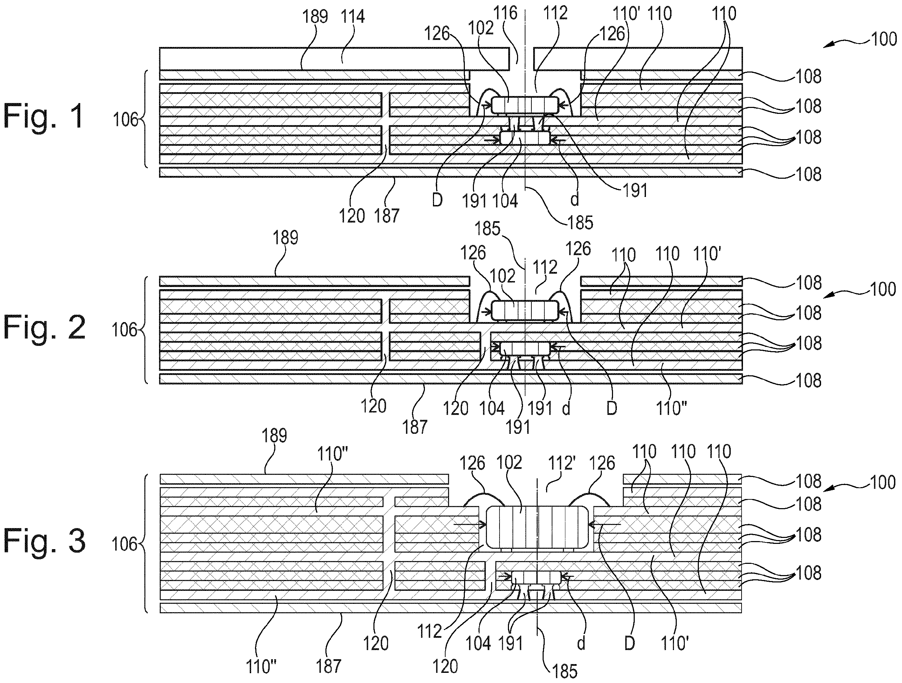

The electric connection of the MEMS can be carried out on the same copper layer to which already the chip has been coupled, preferably from a back side, via copper filled bores (which may be manufactured mechanically, by laser processing, etc.). Such an embodiment is shown in Figure 1. Electric contacting the MEMS can be accomplished by many different procedures, for instance by bonding, soldering, gluing, etc. The manufacture of the cavities can be carried out by using no-flow prepreg or low-flow prepreg to thereby allow to manufacture a hollow space in an interior of the interconnected stack which can then be accessed by a cutting procedure. It is also possible to manufacture the cavity using a buried release layer above which a section of the board can be cut out for generating the cavity. Also the use of inlays or other technologies are possible for forming the cavity.

The connection between chip and MEMS can also be carried out indirectly, i.e. not via one and the same copper layer but by two or more of the electrically conductive layer structures. Such embodiments are shown in Figure 2 and Figure 3. The connection between chip and MEMS can be carried out via copper filled bores of a lower lying layer (see Figure 2). In such an embodiment, cavity formation can be accomplished as described before. It is however alternatively also possible that the cavity is formed via several steps or from at least two cavities of different lateral diameters (see Figure 3). Such an additional stepping allows a shorter wire bond connection with a further inner copper layer. By taking this measure, the MEMS can be retracted in the cavity, wherein the connection can be carried out not only by the copper layer(s) on which the MEMS is/are placed. Assembly of the MEMS can be carried out in the cavity so that the MEMS can be subsequently covered, if desired or required, by a cover and can be closed or at least partially closed (for enabling maintenance of a sensor or actuator exchange between an interior and an exterior of the cavity).

With the described manufacturing architecture, the combination and the assembly with MEMS and assigned chip allow a reduction of the entire board dimension and the thickness of the board. Particularly advantageously in this context is the connection of MEMS and chip via the same interior copper layer, whereby a significant reduction of the mechanical size can be accomplished.

Mounting MEMS and chip above one another is hence advantageous, whereby the entire mechanical dimensions of the board or electronic device can be reduced. Via the cavity, the MEMS can be fully or partially embedded within the interconnected stack. The mentioned components can be protected by the use of a cover with regard to an environment. Such a cover can be a simple planar cover, keeping the dimensions small. However, it is also possible to use a three-dimensional cover such as a cap or lid, for instance when the MEMS protrudes beyond the cavity.

**Figure 1** shows a cross-sectional view of an electronic device 100 according to an example.

The plate-shaped electronic device 100 according to Figure 1 comprises a microelectromechanical system 102 (MEMS), a semiconductor chip 104 configured for cooperating with the microelectromechanical system 102, and a PCB-type laminated stack 106 of a plurality of electrically insulating layer structures 108 (which are here made of prepreg or FR4) and a plurality of electrically conductive layer structures 110 (which are here made of copper) accommodating the microelectromechanical system 102 and the chip 104. The microelectromechanical system 102 may be a pressure sensor or a microphone and may work on the basis of a capacitive detection principle or a piezoelectric detection principle using a movable membrane of the microelectromechanical system 102. The chip 104 may be a logic chip functionally cooperating with the microelectromechanical system 102, for instance pre-processing an electric sensor signal as detected by the microelectromechanical system 102.

In a viewing direction 185 perpendicular to a main surface 187 (for instance the lower main surface 187, which is a horizontal plane according to Figure 1) of the laminated stack 106 (i.e. a direction between the top of Figure 1 and the bottom thereof, which is a vertical direction according to Figure 1), a lateral extension, D, of the microelectromechanical system 102 and a lateral extension, d, of the chip 104 partially coincide. More specifically, the microelectromechanical system 102 and the chip 104 are mounted so that, in the viewing direction 185 perpendicular to the main surface 187 of the laminated stack 106, a contour of the smaller chip 102 is fully enclosed within a contour of the larger microelectromechanical system 102. According to Figure 1, the microelectromechanical system 102 is mounted above the chip 104 so that the chip 104 is not visible from above along the mentioned viewing direction 185, since it is fully covered by the larger microelectromechanical system 102.

According to Figure 1, the chip 104 is fully circumferentially embedded in an interior of the laminated stack 106, i.e. is a buried or embedded chip 104. In contrast to this, the microelectromechanical system 102 is mounted in a cavity 112 formed in a surface portion of the laminated stack 106, i.e. is surface mounted, but protected in a recess. In order to obtain a proper mechanical protection, an upper end of the microelectromechanical system 102 is retracted with regard to an upper main surface 189 of the laminated stack 106 surrounding the cavity 112 so that the microelectromechanical system 102 does not protrude vertically beyond the upper main surface 189 of the laminated stack 106.

To further improve the protection of the sensitive microelectromechanical system 102 (which may comprise a movable element such as a membrane, not shown in Figure 1), the electronic device 100 comprises a cover structure 114 covering part of the cavity 112. The planar cover structure 114 is aligned in parallel to the electrically insulating layer structures 108 and the electrically conductive layer structures 110. In the shown embodiment, the cover 114 has a through-hole 116 for providing acoustic and pressure communication between an interior and an exterior of the cavity 112. In other words, pressure and acoustic waves may propagate through the through hole 116 from an exterior of the electronic device 100 to the microelectromechanical system 102 to be detected there. To obtain a high compactness, the cover 114 is embodied as a flat plate connected on the upper main surface 189 of the laminated stack 106. Hence, the cover 114 does not add much to the entire vertical extension or dimension of the electronic device 100.

The microelectromechanical system 102 and the chip 104 are electrically connected to one another via one and the same of the electrically conductive layer structures 110, i.e. electrically conductive layer structure 110'. More specifically, the microelectromechanical system 102 and the chip 104 are electrically connected to one another by additional bond wires 126 connected to the microelectromechanical system 102 and connected to the mentioned electrically conductive layer structure 110'. This electrically conductive layer structure 110' is then connected to the chip 102 by vias 191. According to Figure 1, the microelectromechanical system 102 and the chip 104 are hence directly electrically connected to a common one of the electrically conductive layer structures 110, i.e. electrically conductive layer structure 110'. This circuitry keeps the electronic device 100 compact. Also mechanically, the bottom of the microelectromechanical system 102 and the top of the chip 104 are both connected to the same electrically conductive layer structure.

In the embodiment of Figure 1, it is furthermore advantageous also for reasons of high signal to noise ratio that the microelectromechanical system 102 and the chip 104 are electrically connected to one another for signal exchange via one and the same - and only via one - of the electrically conductive layer structures 110' plus the direct chip contacting elements 126, 191. This keeps the signal paths short and therefore the influence of noise small. The accuracy of the MEMS-chip assembly is therefore high.

For manufacturing the electronic device 100 according to Figure 1, it is possible to embed and laminate the chip 104 within lower layers of the stack 106. Subsequently, it is possible to form cavity 112 in a surface portion of the interconnected stack 106. Thereafter, the microelectromechanical system 102 may be accommodated in the cavity 112. The obtained structure may then be electrically contacted and closed by the cover 114.

The various layer structures 108, 110 of the laminated stack 106 may each have a thickness in a range between 5 µm and 200 µm. The thickness of each of the microelectromechanical system 102 and the chip 104 may be in a range between 50 µm and 500 µm. Therefore, the electronic device 100, embodied as printed circuit board with embedded MEMS arrangement, is highly compact despite of its high level of electronic functionality. In the embodiment of Figure 1, the cover 114 protects the movable element of the microelectromechanical system 102 as well as the sensitive bond wires 126 from an external mechanical impact while at the same time allowing for an exchange between the exterior and the interior of the cavity 112 via the through hole 116. The latter maintenance of atmospheric communication between the microelectromechanical system 102 and an exterior of the electronic device 100 is for instance advantageous when the microelectromechanical system 102 is configured as a gas sensor, a microphone or even as an actuator such as a loudspeaker.

**Figure 2** shows a cross-sectional view of an electronic device 100 according to another example.

Figure 2 differs from Figure 1 in that Figure 2 does not show a cover 114, although such a cover may be present there as well.

Furthermore, according to the embodiment of Figure 2, the microelectromechanical system 102 and the chip 104 are electrically connected to one another by an additional vertical through-connection 120, i.e. a copper via, extending perpendicular to the laminated stack 106. More precisely, this additional vertical through connection 120 extends parallel to the chip 104 within the contour of the microelectromechanical system 102, thereby further promoting compactness. Moreover, the embodiment of Figure 2 differs from the embodiment of Figure 1 in that not only one of the electrically conductive layer structures 110 (i.e. electrically conductive layer structure 110'), but also a further electrically conductive layer structure 110" is involved in the electric coupling between the chip 104 and the microelectromechanical system 102. The electric connection path can be accomplished in addition via copper filled via(s) 120, still enabling a relatively short signal path. Hence, the full electric coupling path between the chip 104 and the microelectromechanical system 102 is from the microelectromechanical system 102, via bond wires 126, electrically conductive layer structure 110', vertical through-connection(s) 120, electrically conductive layer structure 110", vias 191 to chip 104.

As in Figure 1, also the embodiment of Figure 2 is highly compact, since the microelectromechanical system 102 does not vertically protrude out of the cavity 112 and therefore does not protrude over upper main surface 189 of the laminated stack 106. Due to the vertical alignment of centres of gravities of chip 104 and microelectromechanical system 102 also according to Figure 2, again a highly compact structure in a lateral direction can be obtained.

**Figure 3** shows a cross-sectional view of an electronic device 100 according to still another example.

Figure 3 differs from Figure 2 in that, in addition to the first cavity 112, an additional stacked cavity 112' is provided. In the shown embodiment, inner cavity 112 has a smaller diameter than outer cavity 112' to thereby obtain a stepped multi-diameter cavity. Within the lower and laterally confined cavity 112, the MEMS 102 is accommodated. Within the upper or outer, laterally extended cavity 112', the bond wires 126 connecting the microelectromechanical system 102 with the chip 104 using yet another electrically conductive layer structure 110‴ are also retracted with regard to an exterior surface of the electronic device 100, and are therefore also mechanically protected.

According to Figure 3, the full electric coupling path between the chip 104 and the microelectromechanical system 102 is from the microelectromechanical system 102, via bond wires 126, electrically conductive layer structure 110‴, vertical through-connection(s) 120, electrically conductive layer structure 110', vertical through-connection(s) 120, electrically conductive layer structure 110", vias 191 to chip 104.

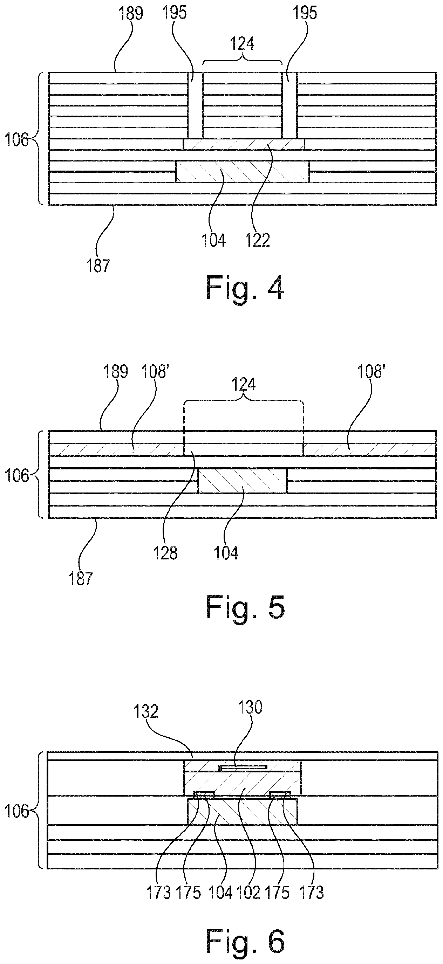

**Figure 4** shows a cross-sectional view of a structure obtained during carrying out a method of manufacturing a cavity 112 of an electronic device 100 according to an exemplary embodiment of the invention.

According to Figure 4, the cavity 112 is formed by arranging a release layer 122 in an interior of the interconnected, in particular laminated, stack 106. Subsequently, it is possible to cut through a portion of the interconnected, in particular laminated, stack 106 above the release layer 122 to thereby form a cut out hole 195 allowing to remove a cut-out portion 124 of the interconnected, in particular laminated, stack 106 above the release layer 122. Advantageously, the (for instance waxy) release layer 122 does not adhere to the rest of the stack 106.

Figure 4 hence illustrates how a cavity 112 can be formed. The interconnected, in particular laminated, stack 106 has an embedded release layer 122, for instance made of wax. When a circumferential hole is drilled (see reference numeral 195), for example by laser or mechanical drilling, an annular structure of the release layer 122 is exposed. Cut-out portion 124 within the circumferential drill hole can be simply taken out and removed from the remainder of the shown semifinished electronic device, since the release layer 122 lacks any significant adhesion to the layers above and below of it. After having taken out this cut-out portion 124, the microelectromechanical system 102 can be mounted there and can be electrically connected to the already embedded chip 104.

**Figure 5** shows a cross-sectional view of a structure obtained during carrying out a method of manufacturing a cavity 112 of an electronic device 100 according to another exemplary embodiment of the invention.

According to Figure 5, the cavity 112 is formed by forming a hollow space 128 in an interior of the interconnected, in particular laminated, stack 106, and removing a cut-out portion 124 of the interconnected, in particular laminated, stack 106 above the hollow space 128.

In the shown embodiment, the buried through-hole or hollow space 128 can be formed by laminating within the stack 106 an electrically insulating layer structure 108' of no-flow prepreg or low-flow prepreg with preformed cut-out inside. During lamination, no resin will hence flow from electrically insulating layer structure 108' in the buried hollow space 128, which will therefore be maintained here. Thereafter, a circumferential cut-out of the material above the buried hollow space 128 will allow to take out section or portion 124, thereby obtaining a cavity 122 for MEMS mounting purposes.

**Figure 6** shows a cross-sectional view of a structure obtained during carrying out a method of manufacturing an electronic device 100 with partially embedded microelectromechanical system 102 according to an exemplary embodiment of the invention.

According to Figure 6, the microelectromechanical system 102 is embedded in a surface portion of the interconnected, in particular laminated, stack 106. Furthermore, a compression protection of a movable element 130 of the microelectromechanical system 102 is foreseen during laminating the interconnected, in particular laminated, stack 106 together with the microelectromechanical system 102. The microelectromechanical system 102 and the chip 104 are electrically connected to one another directly by directly connecting at least one pad 173 of the microelectromechanical system 102 with at least one pad 175 of the chip 104 (for instance by a solder connection).

Figure 6 hence shows an architecture according to which a microelectromechanical system 102 can be embedded within the stack 106. This can be accomplished by arranging a protection structure 132 above movable element 130 of the microelectromechanical system 102. In view of the mechanical protection of the movable element 130 during lamination of the interconnected, in particular laminated, stack 106 including the microelectromechanical system 102, the protection structure 132 provides a mechanical protection during pressurizing the stack 106 including the microelectromechanical system 102 for lamination. After completing lamination, the movable element 130 may be again exposed before first use of the manufactured electronic component 100, for instance by removing or opening protection structure 132.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above.

## Claims

1. A method of manufacturing an electronic device (100), wherein the method comprises:
interconnecting, in particular laminating, a stack (106) of a plurality of electrically insulating layer structures (108) and a plurality of electrically conductive layer structures (110);
at least partially accommodating a microelectromechanical system (102) and a chip (104), being configured for cooperating with the microelectromechanical system (102), on and/or in the interconnected, in particular laminated, stack (106);
arranging the microelectromechanical system (102) and the chip (104) above one another so that, in a viewing direction perpendicular to a main surface of the interconnected, in particular laminated, stack (106), the microelectromechanical system (102) and the chip (104) have at least partially overlapping contours in a lateral direction,
forming a cavity (112) in a surface portion of the interconnected, in particular laminated, stack (106); and
accommodating at least part of the microelectromechanical system (102) in the cavity (112),
the method being **characterized by** the fact that
the cavity (112) is formed by:
forming a hollow space (128) in an interior of the interconnected, in particular laminated, stack (106), and
removing a portion of the interconnected, in particular laminated, stack (106) above the hollow space (128).

2. The method according to claim 1, wherein the method further comprises embedding and laminating the chip (104) within the interconnected, in particular laminated, stack (106).

3. The method according to claim 1, wherein the cavity (112) is formed by:
arranging a release layer (122) in the interconnected, in particular laminated, stack (106); and
cutting through a portion of the interconnected, in particular laminated, stack (106) above the release layer (122) to thereby remove a cut-out portion (124) of the interconnected, in particular laminated, stack (106) above the release layer (122).

4. The method according to claim 1, wherein the hollow space (128) is formed as hole in at least one of the electrically insulating layer structures (108) made of no-flow prepreg or low-flow prepreg.

5. The method according to any of claims 1 to 4, wherein the method further comprises embedding the microelectromechanical system (102) at least partially in a surface portion of the interconnected, in particular laminated, stack (106) so that a movable element (130) of the microelectromechanical system (102) remains coupled to a surrounding atmosphere.

6. The method according to claim 5, wherein the method further comprises providing a temporary compression protection (132) of the movable element (130) of the microelectromechanical system (102) during the interconnecting, in particular laminating the interconnected, in particular laminated, stack (106).

## Patentansprüche

1. Verfahren zur Herstellung einer elektronischen Vorrichtung (100), wobei das Verfahren umfasst:
Verbinden, insbesondere Laminieren, eines Stapels (106) einer Vielzahl von elektrisch isolierenden Schichtstrukturen (108) und einer Vielzahl von elektrisch leitfähigen Schichtstrukturen (110);
zumindest teilweises Aufnehmen eines mikroelektromechanischen Systems (102) und eines Chips (104), der zum Zusammenwirken mit dem mikroelektromechanischen System (102) konfiguriert ist, auf und/oder in dem verbundenen, insbesondere laminierten, Stapel (106);
Anordnen des mikroelektromechanischen Systems (102) und des Chips (104) übereinander, sodass das mikroelektromechanische System (102) und der Chip (104) in einer Blickrichtung senkrecht zu einer Hauptoberfläche des verbundenen, insbesondere laminierten, Stapels (106) zumindest teilweise überlappende Konturen in einer seitlichen Richtung aufweisen,
Bilden eines Hohlraums (112) in einem Oberflächenabschnitt des verbundenen, insbesondere laminierten, Stapels (106); und
Aufnehmen mindestens eines Teils des mikroelektromechanischen Systems (102) in dem Hohlraum (112),
wobei das Verfahren **dadurch gekennzeichnet ist, dass**
der Hohlraum (112) gebildet wird durch:
Bilden eines Hohlraums (128) in einem Innenraum des verbundenen, insbesondere laminierten, Stapels (106), und
Entfernen eines Abschnitts des verbundenen, insbesondere laminierten, Stapels (106) über dem Hohlraum (128).

2. Verfahren nach Anspruch 1, wobei das Verfahren ferner das Einbetten und Laminieren des Chips (104) innerhalb des verbundenen, insbesondere laminierten, Stapels (106) umfasst.

3. Verfahren nach Anspruch 1, wobei der Hohlraum (112) gebildet wird durch:
Anordnen einer Trennschicht (122) in dem verbundenen, insbesondere laminierten, Stapel (106); und
Durchschneiden eines Abschnitts des verbundenen, insbesondere laminierten, Stapels (106) über der Trennschicht (122), um dadurch einen ausgeschnittenen Abschnitt (124) des verbundenen, insbesondere laminierten, Stapels (106) über der Trennschicht (122) zu entfernen.

4. Verfahren nach Anspruch 1, wobei der Hohlraum (128) als Loch in zumindest einer der elektrisch isolierenden Schichtstrukturen (108) gebildet wird, die aus No-Flow-Prepreg oder Low-Flow-Prepreg hergestellt sind.

5. Verfahren nach einem der Ansprüche 1 bis 4, wobei das Verfahren ferner das Einbetten des mikroelektromechanischen Systems (102) zumindest teilweise in einen Oberflächenabschnitt des verbundenen, insbesondere laminierten, Stapels (106) umfasst, sodass ein bewegliches Element (130) des mikroelektromechanischen Systems (102) mit einer umgebenden Atmosphäre gekoppelt bleibt.

6. Verfahren nach Anspruch 5, wobei das Verfahren ferner das Bereitstellen eines temporären Kompressionsschutzes (132) für das bewegliche Element (130) des mikroelektromechanischen Systems (102) während des Verbindens, insbesondere des Laminierens des verbundenen, insbesondere laminierten, Stapels (106) umfasst.

## Revendications

1. Procédé de fabrication d'un dispositif électronique (100), dans lequel le procédé comprend :
l'interconnexion, en particulier la stratification, d'un empilement (106) d'une pluralité de structures de couches électriquement isolantes (108) et d'une pluralité de structures de couches électriquement conductrices (110) ;
le logement au moins partiel d'un système micro-électromécanique (102) et d'une puce (104), qui est configurée pour coopérer avec le système micro-électromécanique (102), sur et/ou dans l'empilement (106) interconnecté, en particulier stratifié ;
l'agencement du système micro-électromécanique (102) et de la puce (104) l'un au-dessus de l'autre de sorte que, dans une direction d'observation perpendiculaire à une surface principale de l'empilement (106) interconnecté, en particulier stratifié, le système micro-électromécanique (102) et la puce (104) présentent des contours se chevauchant au moins partiellement dans une direction latérale,
la formation d'une cavité (112) dans une portion de surface de l'empilement (106) laminé, en particulier stratifié ; et
le logement d'au moins une partie du système micro-électromécanique (102) dans la cavité (112),
le procédé étant **caractérisé par le fait que**
la cavité (112) est formée par :
la formation d'un espace creux (128) à l'intérieur de l'empilement (106) interconnecté, en particulier stratifié, et
le retrait d'une portion de l'empilement (106) interconnecté, en particulier stratifié, au-dessus de l'espace creux (128).

2. Procédé selon la revendication 1, dans lequel le procédé comprend en outre l'enrobage et la stratification de la puce (104) au sein de l'empilement (106) interconnecté, en particulier laminé.

3. Procédé selon la revendication 1, dans lequel la cavité (112) est formée par :
l'agencement d'une couche de libération (122) dans l'empilement (106) interconnecté, en particulier laminé ; et
la découpe à travers une portion de l'empilement (106) interconnecté, en particulier laminé, au-dessus de la couche de libération (122) pour ainsi retirer une portion découpée (124) de l'empilement (106) interconnecté, en particulier laminé, au-dessus de la couche de libération (122).

4. Procédé selon la revendication 1, dans lequel l'espace creux (128) est formé comme un trou dans au moins l'une des structures de couches électriquement isolantes (108) constituées d'un préimprégné sans écoulement ou d'un préimprégné à faible écoulement.

5. Procédé selon l'une quelconque des revendications 1 à 4, dans lequel le procédé comprend en outre l'incorporation du système micro-électromécanique (102) au moins partiellement dans une portion de surface de l'empilement (106) interconnecté, en particulier stratifié, de sorte qu'un élément mobile (130) du système micro-électromécanique (102) reste couplé à une atmosphère environnante.

6. Procédé selon la revendication 5, dans lequel le procédé comprend en outre la fourniture d'une protection de compression temporaire (132) de l'élément mobile (130) du système micro-électromécanique (102) pendant l'interconnexion, en particulier la stratification de l'empilement (106) interconnecté, en particulier stratifié.
